# EUROPEAN PATENT APPLICATION

(11) **EP 2 276 329 A1**
(43) Date of publication of application: **19.01.2011**
(21) Application number: 09165670.2
(22) Date of filing: 16.07.2009
(51) Int. Cl.: H05K 1/02

(54) **Electronic circuit board with a thermal capacitor**

(71) Applicant: ABB Research Ltd., 8050 Zürich (CH)
(72) Inventor: Coppola, Luisa, 5400, Baden (CH); Fabbri, Matteo, 8134, Adliswil (CH); Schmidt, Roland, 5430, Wettingen (CH); Cottet, Didier, CH-8050, Zürich (CH)
(74) Representative: ABB Patent Attorneys

(57) **Abstract**

The invention relates to an electronic circuit board comprising at least one conductor path (6, 6') and at least one component (3) which is one of an electronic component, electric component and heat emitting component and which is connected to said conductor path (6, 6'). At least one thermal capacitor (4) is thermally connected to said conductor (6) in vicinity to said at least one component (3), wherein the at least one thermal capacitor (4) is suitable for transmitting and/or buffering thermal energy of the at least one component.

## Description

The invention relates to thermal transport on a circuit board, more specifically on an electronic circuit board, for example a printed circuit board (PCB), a direct bond copper (DBC), direct aluminum bond (DAB) or any rigid/flexible circuit board.

The heat originating from thermal power dissipation caused by any part of the circuit board such as e.g. electronic, electric or other heat emitting components as well as the conductor paths is usually transported away via conductor paths of the electronic circuit board or via the outer surface of the electronic components. It is also conceivable that a thermal load that is present in the at least one conductor path originates from an electric and/or electronic device or component that is not placed directly on the circuit board addressed in this description and/or due to a comparative high resistive loss of the conductor path on the board itself. The cooling performance via the outer surface can be intensified by the use of additional heat sinks mounted on the device to be cooled and/or fans. However, this invention concentrates on the heat transportation via the conductor paths of the electronic circuit board. The temperature of electronic components has to remain under a maximum temperature to prevent operating faults, life-time degradation or even serious damage of the electronic and/or electric components. The electric components on electronic circuit boards are heated up with the applied current for Joules first law. Therefore, the cooling performance of the electronic circuit board has to respect the maximal appearing current to guarantee the removal of the thermal energy from the electronic component and to prevent heating up over a maximum allowed temperature of the electronic component even in peaks of the current. Such peaks in the current could appear in transients of electrical overload. This means that the cooling performance needs to be adapted thereto.

The state of the art teaches a plurality of techniques to improve heat removal of the electronic circuit board or the amount of transported thermal energy via the conductor paths of the PCB. For example the UK Patent Application UK 2325082 A refers to the heat dissipation in electronic components and the improvement of heat dissipation by the arrangement of through holes. The disadvantage of the state of the art is that the cooling performance of the PCB is adapted to the maximum current appearing in every electronic or other component on the PCB even if this current appears only for a short time like in transients of electrical overload. Thus, complex and expansive electronic circuit board designs has to be chosen only for handling the maximal short time currents in maybe only one electronic component. Since the heat generation is proportional to the quadratic current, the cooling performance has to be increased disproportionally for handling the maximal currents.

The object of the invention is to solve the problems of the state of the art and especially, to find an easy and cheap design of an electronic circuit board which allows safely removing heat from electronic components even during the time of overload currents.

The object is solved by the electronic circuit board according to claim 1. The electronic circuit board comprises at least one conductor path. Thermally connected to said conductor path is at least one component by connecting at least one terminal of the component to the conductor path. The component normally is an electric or electronic component or a heat emitting component like a resistor or even traces, vias or connectors in the circuit board. A thermal capacitor suitable for buffering and/or transmitting thermal energy is also thermally connected in vicinity to said conductor path.

The term vicinity is understood as a relationship in terms of a distance between the at least one thermal capacitor and the at least one determined component. Said distance is selected such that a substantial portion of the thermal load emitted by the at least one determined component is received by the at least one thermal capacitor appointed to said at least one determined component. In other words, the term vicinity is used hereinafter to describe the proximity or neighborhood of the at least one determined component. It shall not be understood of the at least one thermal capacitor in a narrow sense requiring that the at least one thermal capacitor is arranged directly aside the at least one determined component since further components may be thermally and/or electrically connected to the conductor path between the at least one thermal capacitor and the at least one determined component as long as the functional relationship between the at least one thermal capacitor and the at least one determined component remains essentially unaffected.

The thermal capacitor of the inventive electronic circuit board absorbs the thermal energy discharged by the component during overload of the component over the conductor path, temporally buffers the energy and slowly releases the heat to the conductor path and to the ambient, when a transient overload is finished. Thus, the conductor paths or the design of the electronic circuit board and in particular of the component itself can be constructed based on the normal operating current of the component without burdening the conductor path with the increased heat transportation during the overload current. The heat produced by short time maximum currents in single electronic or other components can be buffered in thermal capacitors next to these components.

Where applicable and feasible the cooling effect may be increased in that the electronic circuit board comprises at least one conductor path and at least one component as described above connected to said conductor path. The conductor path has a thermal capacitor region with an increased thickness and/or width compared to the normal thickness and/or width of the conductor path. The increased thickness and/or width is arranged in vicinity to the component suitable for buffering and/or transmitting thermal energy. Thus, if a thermal level of a conductor path needs to be lowered, broadening the conductor path or the conductor paths by widening and/or thickening the cross-section at a place other than in the vicinity of further thermal dissipating components becomes an option.

The claimed thermal capacitor region can absorb the thermal energy discharged by the component in the neighborhood over the conductor path, temporally buffer the energy and slowly release the heat to the conductor path, when a transient overload is finished. Thus, the conductor paths or the design of the electronic circuit board have to be adapted only in the region of the component and not over the complete circuit board.

The dependent claims refer to further advantageous embodiments of the invention.

In one embodiment, said thermal capacitor is thermally connected to said conductor path neighboring the component and on the same side of the circuit board as the component. Consequently, thermal energy has to be conducted only over a small distance in the conductor path to the thermal capacitor.

Alternatively or in addition thereto, said thermal capacitor is thermally connected to said conductor path on the other side of the component and opposing the component. This is especially advantageous in combination with the feature that the thermal capacitor is connected over the same connection to the conductor as the component and that the connection has a better heat transport capability than the conductor path. Thus, the heat generated by the component can be conducted without entering the conductor path to the component on the other side and be buffered there. The conductor path is not blocked by the suddenly increased amount of heat transported over the conductor path. By using connections which comprise a terminal of the component and solder having a bigger cross-sectional area in direction of the heat flow than the cross-sectional area of the conductor path, heat can rapidly be conducted to the thermal capacitor and at the same time heat can partly be conducted away over the conductor path. Therefore, optimized cooling effect of the component is achieved.

In one embodiment of the invention, said thermal capacitor is single bodied. Therefore, the thermal capacitor is easy and cheap to construct. The material shall essentially feature good thermal properties. In other words, said at least one thermal capacitor comprises at least one material having a heat conductance value of at least the heat conductance value of the conductor path, i.e. a good thermal conductivity. Depending on the requirements and the intended use, the thermal capacitor can even be made of a composite such as a metal matrix component, nano carbons, nano carbon tubes and the like. In a basic embodiment, the at least one thermal capacitor comprises advantageously an aluminium or copper-based material having good properties of thermal conductance and a large heat capacity. Where applicable, the material of the heat capacitor has at least a heat conductivity of the conductor path.

However, the thermal capacitor may comprise multiple parts instead of a monobloc body without deriving from the spirit of the present invention.

In one embodiment, the thermal capacitor is soldered to the conductor path. However, the invention is not restricted to solder-connections, but includes even connection by clipping, brazing, press-fitting, sintering, snap-fitting/clicking the thermal capacitor to the conductor path. Where applicable, also a fixation of the thermal capacitor comprising a thermal paste is an option.

In one embodiment, said thermal capacitor has the same or approximately similar dimensions as said component. Therefore, the thermal capacitor does not project over the component and does not need additional constructional space. In addition, on the one hand, the amount of heat absorbable in the thermal capacitor depends on the size of thermal capacitor and its heat capacitance and, on the other hand, the amount of heat generated in the component depends as well on the size of the component. The shape of the thermal capacitor can be chosen also only in one direction or in only two directions similar to the component. For example the height or the height and the depth of the thermal capacitor can be chosen similar to the component.

Another embodiment for saving space and being well combinable with the previously described one is that a shape of the thermal capacitor on the side facing the component at least partly corresponds to the negative form of the component on its side facing the thermal capacitor such that the thermal capacitor can be mounted as close as possible to the component without touching it. In other words, a shell surface of the thermal capacitor is at least partially complementary to a shell surface of the at least one component. In particular, the thermal capacitor is mounted directly neighbored to the heat generating component. An embodiment of the heat capacitor surrounds the component with the shell surface being complementary to the shell surface of the at least one component. If the distance between the component and the heat capacitor is chosen adequate, a chimney effect arises. The chimney effect supports the cooling effect of the component and the heat capacitor.

In one embodiment, said thermal capacitor is dimensioned in one direction at least as large as the width of the conductor path. Thus, the heat flow is not affected negatively by a bottleneck or a narrow point in the heat capacitor. Therefore, it is as well advantageous to connect a whole bottom surface of the thermal capacitor to the conductor path to prevent any narrow points in the heat flow.

In another embodiment, the thermal capacitor is formed as a closed block suitable for having small contact surface with the ambience. Such a form can be a cylinder or a general cuboid, for example. This form shows minimal contact surface with the ambience, normally air. The dissipation of heat to the ambient is thereby slowed down which reduces the airflow needed inside a electronic apparatus.

In one embodiment, the at least one thermal capacitor is located at a distance from the at least one component, wherein the distance is chosen such that a thermal load being fed in the conductor path by the at least one component in an operating state of the electronic circuit remains below a preselected thermal threshold. Preferably, at least two thirds of the thermal load emitted from the at least one component are received by the at least one thermal capacitor appointed to said at least one component.

In addition or alternatively thereto, a plurality of thermal capacitors is connected to the conductor path.

In a further embodiment, a further component is arranged between the component and the heat capacitor, in particular that the further component is insensible to heat.

In one embodiment, the heat capacity and heat conductivity of the heat capacitor is designed such that the additional heat of transient currents being higher than the nominal current of the component and/or the conductor path can be buffered in the heat capacitor for at least 100 sec, in particular for 30 sec. For calculating the heat amount arising in this period, a maximal occurring current can be used.

The described embodiments refer to single additional features of the invention according to claim 1. All features of the embodiments are combinable with each other. In the following, three exemplary embodiments of the claimed electronic circuit will be described based on the drawing. The drawing shows:
- Fig. 1: a first embodiment of an electronic circuit according to the invention with the thermal capacitor mounted on the same side of the circuit board as the electronic component;
- Fig. 2: a second embodiment of the electronic circuit using a different mounting technique;
- Fig. 3: a third embodiment of the electronic circuit with the thermal capacitor being mounted on the other side;
- Fig. 4: a diagram comparing temperature over time of state of the art electronic circuits and of the claimed electronic circuit;
- Fig. 5: the diagram comparing temperature over time of state of the art electronic circuits and of the claimed electronic circuit;
- Fig. 6: a fourth embodiment of the electronic circuit using increased thickness of a conductor path as thermal capacitor
- Fig. 7: a conductor path of a fifth embodiment of the invention with an increased width; and
- Fig. 8: a conductor path of a sixth embodiment of the invention with a plurality of heat capacitors.

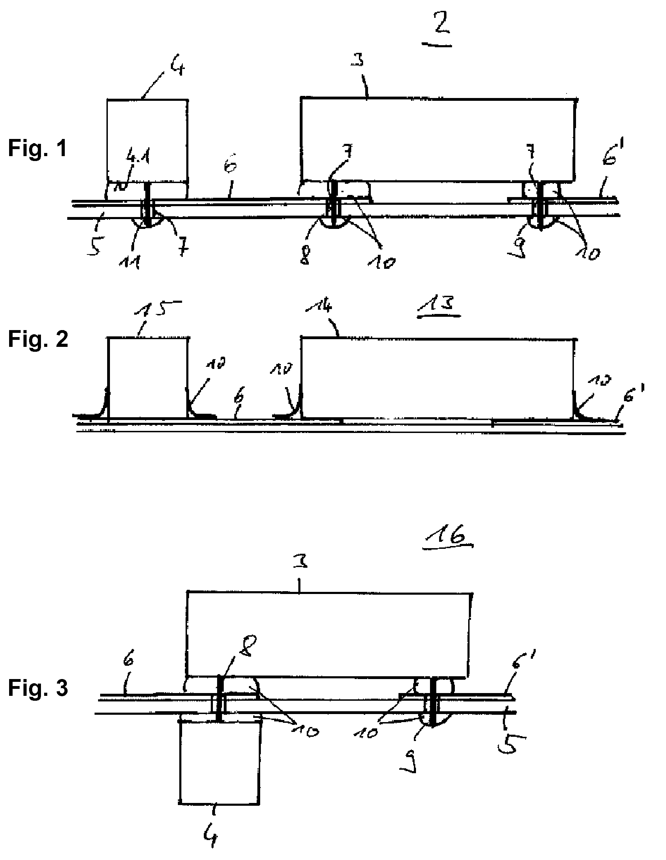

Fig. 1 shows a first exemplary embodiment of the invention. The electronic circuit board 2 comprises a power semiconductor component 3 as electronic component and a copper block 4 as thermal capacitor. Instead of a power semiconductor component 3, heat emitting components such as resistors can be used. The electronic circuit board 2 comprises an insulating layer 5 and conductor paths 6 and 6' attached to at least one side of the insulating layer 5. The electronic circuit board 2 comprises through holes 7 in the region of the conductor paths 6 and 6' for fixing the electronic component and for connecting the conductor paths 6 and 6' with terminal pins 8, 9 of the electronic component 3.

The power semiconductor component 3 has in this embodiment two terminal pins 8 and 9. The pins 8 and 9 of the power semiconductor component 3 are soldered in the through holes 7 of the electronic circuit board 2. The solder 10 fixes the pins 8 and 9 in the through holes 7 and consequently, fixes the power semiconductor component 3 on the electronic circuit board 2. In addition, the solder 10 creates a thermal and electrical connection between the terminal pins 8, 9 of the power semiconductor component 3 and the conductor path 6, equally for the terminal pin 9 and the conductor path 6'. Therefore, the heat produced in the power semiconductor component 3 can be transported away via the conductor paths 6 and 6'.

The copper block 4 comprises a fixing pin 11 for the connection with the electronic circuit board 2. The copper block 4 is soldered to the conductor path 6 in the same way as the power semiconductor component 3. The copper block 4 is soldered such to the conductor path 6 that the bottom surface 4.1, preferably the entire bottom surface, of the copper block is soldered to the conductor path 6. Therefore, maximum heat flow between the copper block 4 and the conductor path 6 is guaranteed. A thermal connection is now established between the power semiconductor component 3 and the copper block 4 by the conductor path 6. The copper block 4 is mounted as close as possible to the power semiconductor component 3 without any further electronic components in between for not heating up additional components and for an improved heat flow from the power semiconductor component 3 to the copper block 4. Certainly, the arrangement of the copper block 4 has to respect distances to the power semiconductor component 3 which could disturb the functionality of the power semiconductor component 3 by electromagnetic emissions or by direct current flow over the exterior walls of the power semiconductor component 3 and the copper block 4. If such a direct contact between the power semiconductor component 3 and the copper block 4 does not disturb the functionality of the power semiconductor component 3, the heat flow from the power semiconductor component 3 to the copper block 4 can further be improved by the heat flow over the outer walls of the power semiconductor component 3 and directly to the copper block 4. In contrast thereto, it is even possible to arrange a further component on the conductor path 6 between the copper block 4 and the power semiconductor component 3, in particular a further component which is not sensible to heat and does not produce too much heat such that the heat flow from the power semiconductor component 3 to the copper block 4 is not remarkably disturbed.

The heat of the power semiconductor component 3 and/or of the copper block 4 can be removed by natural convection or by the support of a fan (not shown).

In the following, the functionality of the invention is described on the basis of the first exemplary embodiment. The heat produced in the power semiconductor component 3 flows into the conductor paths 6 and 6' and is transported away. During normal operating currents, the heat of the power semiconductor component 3 is dissipated efficiently without consideration of the copper block 4, because the heat transport characteristics are designed for heat production during normal operating currents. During transient overloads, an overload current appears for a short time in the power semiconductor component 3 and the temperature therein rises. Therefore, the heat flow out of the power semiconductor component 3 increases. Since the increased heat amount cannot be completely conducted away by the overburdened conductor path 6, the heat flows partly into the copper block 4. The copper block 4 buffers the heat during this heat maximum and releases the heat slowly after such a heat production maximum. Thus, the copper block 4 can buffer a certain amount of heat and can smooth the temperature rise in the power semiconductor component 3 during high currents for a limited time period. This has the advantage that temperatures due to short time overload currents can be overcome by simply buffering the heat energy and not by complex and expansive design changes in the electronic circuit board 2 which are needed only for small time periods. Typical length of the transient current is up to two seconds for low voltage drives for example and soft starters can have startup transients of up to 30 seconds. Therefore, as an example, the required heat capacity of the copper block 4 is calculated based on a transient current period of 30 seconds.

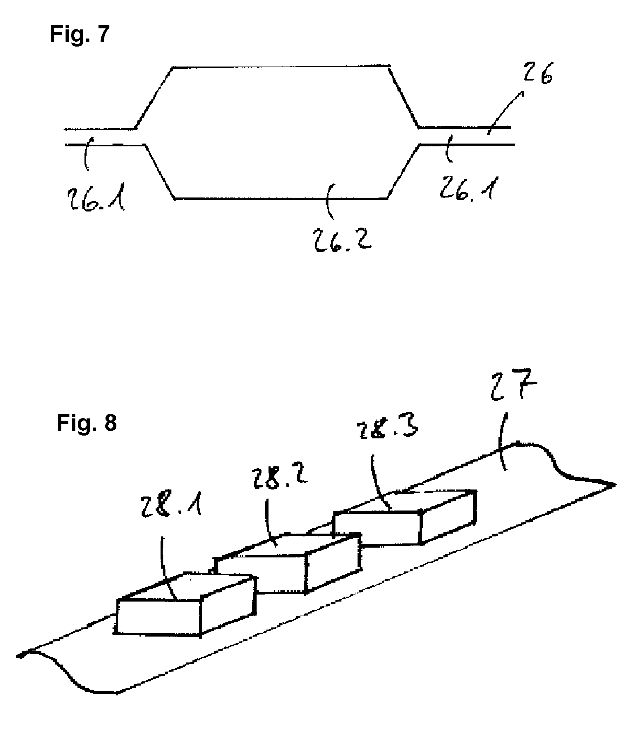

In other words, the copper block 4 significantly reduces the thermal impedance of the system out of power semiconductor component 3, copper block 4 and conductor paths 6, 6' and increases its thermal capacitance. Consequently, more heat is transported away over the conductor path 6. Certainly, the heat flow from the power semiconductor component 3 can be further improved by an additional copper block 4 on the second terminal side of the power semiconductor component 3, i.e. mounted on the conductor path 6'. This can be generalized to each terminal of an electronic component. Fig. 8 shows a conductor path 27 with a plurality of copper blocks 28.1, 28.2 and 28.3 mounted thereon. This further increases the heat capacitance of the conductor path for buffering the heat produced during transient currents. A plurality of small copper blocks 28.1, 28.2. and 28.3 can even substitute a big copper block such as copper block 4. This saves construction space and distributes the heat of the semiconductor component 3 or 14 better.

The functionality of the copper block 4, i.e. the buffering and transmitting of the heat produced during transients, defines the design of copper block 4, i.e. the heat capacitance of the copper block 4, and the distance from the component. The copper block 4 is designed and arranged in a distance to the component such that the power semiconductor component 3 and the electronic circuit board 2 around the power semiconductor component 3 remain under a thermal threshold during an operating state of the power semiconductor component 3, in particular during a transient current being larger than the nominal current of the power semiconductor component 3. The thermal threshold is defined by solder limits, limits warranted for the power semiconductor component 3 by the manufacturer, limits warranted for neighboring components by the manufacturer, or limits of the electronic circuit board 2. A good condition to fulfill such a thermal threshold is to buffer at least 2/3 of the heat produced by the power semiconductor component 3 and transmitted by the copper block 4.

Fig. 2 and Fig. 3 show a second and a third alternative embodiment of the invention. The functionality of the second and third embodiment corresponds basically to the first one. Fig. 2 shows the second embodiment of the invention 13 where a power semiconductor component 14 and a copper block 15 are soldered by surface mounted device (SMD) technique to an electronic circuit board 13. Here the components 14 and 15 are glued to the electronic circuit board 13 and fixed laterally by solder 10. The power semiconductor component 14 and the copper block 15 are thermally and electrically connected by solder 10 to the conductor path 6 of the electronic circuit board 13. The power semiconductor component 14, the copper block 15 and the electronic circuit board 13 have the same design and arrangement as in the first embodiment of the invention except for the different fixing system. Therefore, the electronic circuit board 13 has no through holes and the power semiconductor component 14 and the copper block 15 have no pins. There are several fixing techniques such as clipping, brazing, press-fitting, sintering, snap-fitting which can be used as alternatives of the shown one.

Fig. 3 shows a third embodiment of the invention. The electronic circuit board 16 has the same components, i.e. power semiconductor component 3, the copper block 4, the insulating substrate 5 and the conductor paths 6 and 6' as the first embodiment of the invention. Only an alternative arrangement of the copper block 4 is shown. In the electronic circuit board 2 of the first embodiment, the heat flows over the conductor path 6 to the copper block 4 being mounted on the same side of the electronic circuit board 2 as the power semiconductor component 3. For very high currents, the heat of the power semiconductor component 3 cannot be conducted rapidly enough to the copper block 4, because the conductor path 6 is a bottleneck in the thermal flow system consisting of power semiconductor component 3, conductor path 6 and copper block 4. This problem is solved by the arrangement of the copper block 4 on the other side of the electronic circuit board 2, on the same terminal pin 8. Thus, the terminal of the power semiconductor component 3 faces the terminal of the copper block 4 such that a direct thermal connection between the power semiconductor component 3 and the copper block 4 exists without the bottleneck of the conductor path 6. If the direct connection has a larger cross-sectional area in the heat flow direction than the conductor path 6, the heat transport capability of the system is improved. In some applications, it is even advantageous to arrange the copper block 4 on the opposite site, because next to the power semiconductor component 3 the space is already occupied by further electronic components. The copper block 4 can even have an own pin which is fixed in the same through hole as the pin 8 of the power semiconductor component 3 or is fixed in a second neighboring through hole such that both pins are connected by the solder 10. This improves further the cross-sectional area in the heat flow direction of the direct connection between the power semiconductor component 3 and the copper block 4, because the cross-sectional area of the connection limited by the cross-sectional of the through hole is doubled.

If the copper block 4 is on the same side as the power semiconductor component 3, it is advantageous to form the copper block 4 such that it has the same or a similar height as the power semiconductor component 3 as shown in the figures. The height is the distance in a perpendicular direction from the electronic circuit board 2 between the electronic circuit board 2 and the point of the copper block 4. In addition or alternatively, the depth of the copper block 4 is chosen similar to the depth of the power semiconductor component 3. The depth is the dimension in direction showing here rectangular in the plane of projection, i.e. the direction being rectangular to the direction of the height and rectangular to the direction formed by the line arrangement of the copper block 4 and the power semiconductor component 3. If the copper block 4 has the same height and the same depth as the power semiconductor component 3, the copper block 4 does not project over the power semiconductor component 3 in the two described directions. This saves worthy space for components in the vicinity.

In general, the size of the copper block 4 regulates the amount of heat the copper block 4 can buffer and thus, how much additional heat produced by transient electrical overloads can be buffered therein. In combination with the adaption of the dimensions of the copper block 4, the size can be regulated about the dimension in the third direction pointing from the power semiconductor component 3 to the copper block 4. Alternatively, the dimension of the copper block 4 is chosen by the free space on the electronic circuit board 2. To further save construction space the form of the copper block 4 on the side facing the power semiconductor component 3 is chosen like the negative form of side of the power semiconductor component 3 facing the copper block 4, i.e. that a shell surface of the copper block 4 is at least partially complementary to a shell surface of the power semiconductor component 3. For example, if the power semiconductor component 3 is formed like a cylinder and the circular outer wall of the cylinder points versus the copper block 4, one outer wall versus the power semiconductor component 3 can be chosen as the corresponding concave cylinder form. Thus, the copper block 4 can be arranged very close to the power semiconductor component 3. If the copper block 4 is designed such that the copper block 4 surrounds the power semiconductor component 3 laterally and if the copper block 4 comprises an opening near the surface of the electronic circuit board 2, a chimney effect can be created. The chimney effect further supports the cooling effect of the power semiconductor component 3 and of the copper block 4, while the construction space around the power semiconductor module 3 is effectively used.

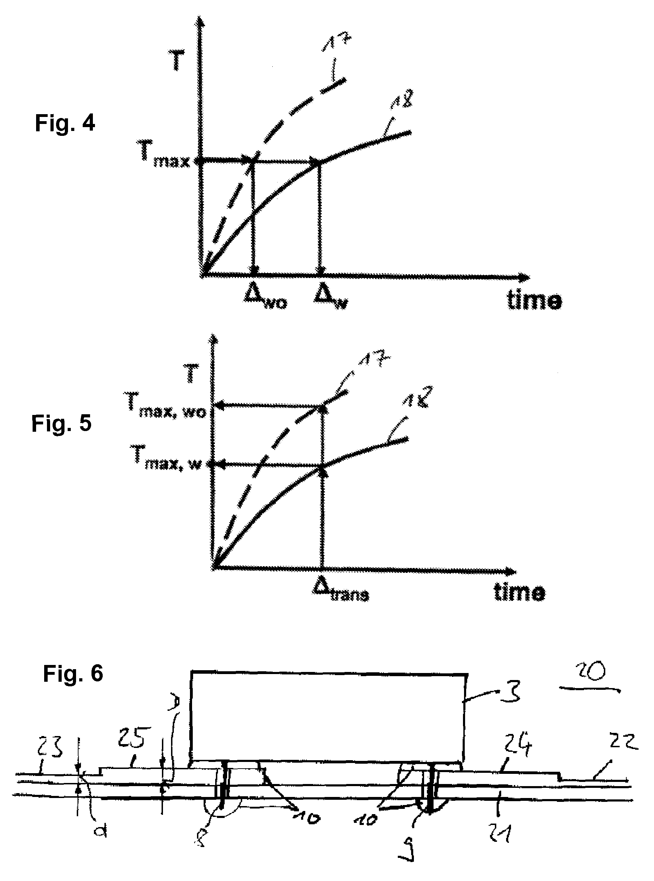

Fig. 4 and 5 show the temperature of the power semiconductor component 3 over the time during transient overload current in the power semiconductor component 3. The line 17 shows the temperature-rise of a power semiconductor component without a neighboring copper block 4 and the line 18 the temperature-rise of the power semiconductor component 3 or 14 with the neighboring copper block 4 or 15. The temperature line 17 increases much faster than the temperature line 18 of the inventive electronic circuit 1, 12 or 16. Without a copper block, the maximal temperature Tₘₐₓ of the power semiconductor component is reached rapidly after the time Δ_{wo}. In the electronic circuit according to the invention, a maximal allowed temperature Tₘₐₓ is reached later after the time Δ_{w}. In the electronic circuit according to the invention, the transient overload current can be applied longer than in electronic circuits without a copper block 4 or 13 as thermal capacitor. Fig. 5 shows that a power semiconductor component 3 after the transient overload current applied for the time period Δₜᵣₐₙₛ to the power semiconductor component 3 without a neighboring copper block 4 shows higher temperature T_{max, wo} than the temperature T_{max, w} of the power semiconductor component 3 or 14 with a neighboring copper block 4. Thus, for a given transient time Δₜᵣₐₙₛ the temperature T at the end of the transient current overload is reduced with the copper block 4 in vicinity of the power semiconductor component 3 or 14.

The thermal capacitor is not restricted to copper. Any material showing good heat transportation properties for rapidly absorbing heat energy into the thermal capacitor 3 or 14 and relatively large heat capacitance are possible such as aluminium or any alloys of aluminium and/or copper. Metals in general are advantageous, because they have high heat flow properties and are well connectable by soldering to the conductor path 6. However, the thermal capacitor can even be made of a composite such as a metal matrix component, nano carbons, nanotubes and the like, as long as the thermal capacitor has a good thermal conductivity.

Fig. 6 shows an electronic circuit board 20 according to the fourth exemplary embodiment of the invention. The electronic circuit board 20 having an insulating layer 21 and two conductor paths 22 and 23. The conductor paths 22 and 23 have through holes as the electronic circuit board 2. The power semiconductor component 3 is the same as in the first and third embodiment of the invention and is soldered to the conductor paths 22 and 23 through pins 8 and 9 in said through holes. The conductor paths 22 and 23 each show a region 24 and 25, respectively, in vicinity to the electronic component with an increased thickness D as thermal capacitor region compared to the regions of the conductor path being further away having a thickness d. The distance is measured by following the conductive connection. Thickness is the dimension in the direction perpendicular to the plane of the electronic circuit board 20. In this embodiment the conductor paths 22 and 23 show a step in the thickness of the conductor paths 22 and 23, when the regions 24 and 25 are entered. Instead of a step, even a continuous increase in thickness is realizable. In the shown embodiment, the semiconductor component is mounted directly on the regions 24, 25 with the increased thickness.

The thickness d of the conductor paths 22 and 23 can be increased to thickness D only by a small amount with minor elevation of the position of the power semiconductor component 3 (not shown). In another embodiment the thickness of the conductor paths 22, 23 in a region directly between the power semiconductor component 3 and the substrate 21 is not increased such that the power semiconductor component 3 is not elevated. The region directly neighboring the power semiconductor component 3 and said region under the power semiconductor component 3 is increased in thickness for enlarging the thermal capacitance of the conductor paths 22, 23 (not shown). In an alternative embodiment, instead of the thickness or in addition to the thickness increase, the width of the conductor path can be enlarged in vicinity of the power semiconductor component 3 as shown in Fig. 7. Fig. 7 shows the conductor path 26 according to a fifth embodiment of the invention. The conductor path 26 increases from a region 26.1 of normal width of the conductor path 26 to a region 26.2 of increased width of the conductor path 26 for further increasing the thermal capacitance of the conductor path 26 in the region 26.2. It may prove to be advantageous if the power semiconductor component 3 is mounted in the region 26.2. The width is the dimension in the direction being parallel to the plane of the electronic circuit board and rectangular to the thermal and electrical conducting direction. The fourth and fifth embodiments of the invention are especially advantageous for applications with much space on the electronic circuit board 20.

The first, second, third, fourth, fifth and/or sixth embodiment of the invention and their sub-embodiments can be advantageously combined to further increase the thermal capacitance of the conductor path in vicinity of a power semiconductor component 3 or 14. Such a circuit board with a conductor path 22, 23 increased in thickness in vicinity of the power semiconductor component 3 and with a thermal capacitor 4 mounted in vicinity to the power semiconductor component 3 can be a solution for extreme high maximum currents or for overload currents being applied a longer, but still limited period of time.

The invention is not restricted to power semiconductor components, but applicable for all kinds of electronic components and heat emitting components on electronic circuit boards. But the invention is especially advantageous for power semiconductor components such as 3 and 14, because very high currents are applied to power semiconductor components 3 and 14 and they are quite sensible to high temperatures.

Such a thermal capacitor can be mounted or such a thermal capacitor region can be designed on the electronic circuit board 2 at every electronic component which shows for short times high currents or at every electronic component being shortly heated up over a heat amount which can be transported away by the electronic circuit board. For very high maximal currents, large thermal capacitors or very thick and large thermal capacitor regions can be applied. In addition, a thermal capacitor or a thermal capacitor region can be mounted or designed on more conductor paths around the electronic component, e.g. at all conductor paths being connected with the electronic component.

The invention is not restricted to printed circuit boards, but it can be applied to any kind of circuit boards. The circuit board shown here has two conductors but any number of conductors is possible, at least one conductor is necessary for the invention.

The invention is not restricted to the described embodiments. All embodiments described are combinable with each other. A preferred embodiment does not restrict the invention to the preferred embodiment, alternatives or combinations with other embodiments are included in the scope of protection.

## Claims

1. An electronic circuit board comprising
at least one conductor path (6, 6');
at least one component (3, 14) being one of an electronic component, electric component and heat emitting component, the component connected to said at least one conductor path (6, 6');
**characterized by**
at least one thermal capacitor (4, 15, 28.1, 28.2, 28.3) suitable for transmitting and/or buffering thermal energy in an operating state of the electronic circuit board, wherein the at least one thermal capacitor (4, 15) is thermally connected to at least one of said conductor (6) in vicinity to said at least one component (3, 14) and the at least one conductor path (6, 6').

2. Electronic circuit board according to claim 1,
**characterized in**
**that** the at least one thermal capacitor (4, 15, 28.1, 28.2, 28.3) of the circuit board (2, 13) is thermally connected to said conductor path (6, 6') neighboring the at least one component (3) and on the same side of the electronic circuit board (2, 13) as the at least one component (3, 14).

3. Electronic circuit board according to claim 1,
**characterized in**
**that** the at least one thermal capacitor (4) is connected to said conductor path (6, 6') on the averted side of the at least one component (3) of the electronic circuit board (2, 13).

4. Electronic circuit board according to anyone of claims 1 to 3,
**characterized in**
**that** said at least one thermal capacitor (4, 15, 28.1, 28.2, 28.3) comprises at least one material having a heat conductance value of at least the heat conductance value of the conductor path.

5. Electronic circuit board according to claim 4,
**characterized in**
**that** said at least one thermal capacitor (4, 15, 28.1, 28.2, 28.3) comprises copper or aluminium.

6. Electronic circuit board according to anyone of claims 1 to 5,
**characterized in**
**that** said at least one thermal capacitor (4, 15, 28.1, 28.2, 28.3) is soldered, brazed, clipped, press-fitted, sintered or snap-fitted to the at least one conductor path (6, 6').

7. Electronic circuit board according to anyone of claims 1 to 6,
**characterized in**
**that** a shell surface of the at least one thermal capacitor (4, 15, 28.1, 28.2, 28.3) is at least partially complementary to a shell surface of the at least one component (3, 14).

8. Electronic circuit board according to anyone of claims 1 to 7,
**characterized in**
**that** at least one thermal capacitor is located at a distance from the at least one component (3, 14), wherein the distance is chosen such that a thermal load being fed in the conductor path (6, 6') by the at least one component (3, 14) in an operating state of the electronic circuit remains below a preselected thermal threshold.

9. Electronic circuit board according to claim 8,
**characterized in**
**that** at least two thirds of the thermal load emitted from the at least one component (3, 14) are received by the at least one thermal capacitor (4, 15, 28.1, 28.2, 28.3) appointed to said at least one component.

10. Electronic circuit board according to anyone of claims 1 to 9,
**characterized in**
**that** a plurality of thermal capacitors are connected to the conductor path (6, 6').

11. Electronic circuit board according to anyone of claims 1 to 10,
**characterized in**
**that** a further component, in particular a heat insensible further component, is electrically connected to the at least one conductor path (6, 6') connecting the at least one component (3, 14) and the at least one thermal capacitor (4, 15, 28.1, 28.2, 28.3).

12. Electronic circuit board according to anyone of claims 1 to 11,
**characterized in**
**that** the at least one thermal capacitor (4, 15, 28.1, 28.2, 28.3) is designed such that the additional heat of transient currents being higher than the nominal current of the at least one component (3, 14) and/or the conductor path (6, 6') can be buffered in the at least one thermal capacitor (4, 15, 28.1, 28.2, 28.3) for at least 100 seconds, in particular for at least 30 seconds.

13. Electronic circuit board according to anyone of claims 1 to 12,
**characterized in**
**that** the at least one thermal capacitor (4, 15, 28.1, 28.2, 28.3) is thermally connected by means of the same connection (8, 10) to the conductor path (6, 6') as the at least one component (3, 14).

14. Electronic circuit board according to claim 13,
**characterized in**
**that** the connection (8, 10) has a larger cross-sectional area in the direction of the heat flow than the conductor path (6, 6').

15. Electronic circuit board according to anyone of claims 1 to 14;
**characterized in that**
the at least one conductor path (22, 23; 26) has at least one thermal capacitor region (24, 25; 26.2) with a thickness (D) and/or a width being increased over its regular thickness (d) and/or width in vicinity to at least one of the at least one component (3) suitable for transmitting or buffering thermal energy and the at least one conductor path (22, 23; 26).
